# FASCICULE DE BREVET EUROPEEN

(11) **EP 3 046 143 B1**
(45) Date de publication et mention de la délivrance du brevet: **29.03.2023**
(21) Numéro de dépôt: 16151100.1
(22) Date de dépôt: 13.01.2016
(51) Int. Cl.: H01L 21/84, H01L 21/768, H01L 23/485, H01L 23/528, H01L 23/535, H01L 21/822, H01L 27/06

(54) **PROCEDE DE REALISATION D'UN CIRCUIT ELECTRONIQUE INTEGRE TRIDIMENSIONNEL**
VERFAHREN ZUR HERSTELLUNG EINES DREIDIMENSIONALEN INTEGRIERTEN SCHALTKREISES
METHOD FOR PRODUCING A THREE-DIMENSIONAL INTEGRATED ELECTRONIC CIRCUIT

(30) Priorité: 16.01.2015 FR 1550335
(43) Date de publication de la demande: 20.07.2016
(73) Titulaire: Commissariat à l'Énergie Atomique et aux Énergies Alternatives, 75015 Paris (FR)
(72) Inventeur: PREVITALI, Bernard, 38100 Grenoble (FR); VINET, Maud, 44690 La Haye Fouassiere (FR)
(74) Mandataire: Brevalex

(56) Documents cités:
- EP-A2- 2 575 162
- US-A1- 2003 129 829
- US-A1- 2007 267 723
- US-A1- 2012 088 367
- US-B1- 8 906 755
- IRISAWA T ET AL: "Demonstration of ultimate CMOS based on 3D stacked InGaAs-OI/SGOI wire channel MOSFETs with independent back gate", ENERGY EFFCIENCY CONVENTION (SAEEC), 2012 SOUTHERN AFRICAN, IEEE, 9 juin 2014 (2014-06-09), pages 1-2, XP032640174, ISSN: 0743-1562, DOI: 10.1109/VLSIT.2014.6894395 ISBN: 978-1-4673-5226-0 [extrait le 2014-09-08]
- VINET M ET AL: "Monolithic 3D integration: A powerful alternative to classical 2D scaling", 2014 SOI-3D-SUBTHRESHOLD MICROELECTRONICS TECHNOLOGY UNIFIED CONFERENCE (S3S), IEEE, 6 octobre 2014 (2014-10-06), pages 1-3, XP032731359, DOI: 10.1109/S3S.2014.7028194

## Description

### DOMAINE TECHNIQUE ET ART ANTÉRIEUR

L'invention concerne le domaine de la réalisation des circuits électroniques intégrés tridimensionnels comportant des composants électroniques correspondant par exemple à des transistors CMOS de conductivités différentes.

Par rapport à un circuit électronique intégré classique réalisé à partir d'une unique couche de semi-conducteur, un circuit électronique intégré tridimensionnel comporte plusieurs niveaux de composants électroniques, tels que des transistors MOS, superposés les uns au-dessus des autres. Un des intérêts de l'intégration en trois dimensions des circuits électroniques intégrés est l'augmentation de la densité d'intégration des composants électroniques dans ces circuits électroniques intégrés tridimensionnels par rapport aux circuits électroniques intégrés classiques, ce qui permet d'obtenir notamment une diminution des temps de propagation moyens dans les interconnexions électriques de ces circuits reliées aux composants électroniques.

Actuellement, il existe deux familles d'intégrations en trois dimensions de circuits électroniques intégrés.

La première, appelée intégration parallèle, consiste à réaliser en parallèle et séparément sur plusieurs substrats, ou wafers, les composants électroniques d'un circuit électronique intégré jusqu'à leur achèvement, puis à coller les substrats les uns sur les autres et à réaliser enfin des interconnexions électriques communes pour relier électriquement entre eux les composants électroniques formés sur les différents substrats. Le collage entre les substrats peut être réalisé après une siliciuration des contacts électriques des composants électroniques, ou bien après la réalisation des premiers niveaux de métallisations sur chacun des substrats.

Le document US 6 624 046 B1 décrit un exemple d'intégration parallèle comportant la réalisation d'un circuit intégré tridimensionnel à partir de plusieurs circuits fabriqués séparément à partir de différents substrats, les circuits étant ensuite empilés et interconnectés entre eux par des interconnexions électriques verticales. Chaque nouvelle couche de circuit est reportée sur l'empilement de circuits réalisé et des trous sont formés à travers cette nouvelle couche de circuit, en regard de zones de contacts électriques préalablement définies sur l'empilement. Un matériau électriquement conducteur est alors déposé dans ces trous afin de réaliser les interconnexions électriques entre cette nouvelle couche de circuit et le reste de l'empilement.

Dans une telle intégration parallèle, un deuxième substrat comprenant des composants électroniques réalisés par plusieurs niveaux de lithographie est reporté sur un premier substrat comprenant également des composants électroniques réalisés par plusieurs niveaux de lithographie. L'étape de collage des deux substrats doit être réalisée en alignant ces deux substrats l'un par rapport à l'autre afin que les motifs (composants électroniques, zones de contact électrique, etc.) définis sur le deuxième substrat soient convenablement positionnés par rapport aux motifs définis sur le premier substrat. Or, les performances actuelles d'alignement lors d'un tel collage sont limitées à quelques microns, ce qui exclut la possibilité d'utiliser cette méthode pour réaliser par exemple des interconnexions électriques locales dans des zones denses du circuit. L'expression « interconnexion électrique locale » désigne une interconnexion électrique entre deux composants électroniques voisins (disposés l'un en face de l'autre ou l'un à côté de l'autre), par exemple deux transistors voisins.

Avec une telle intégration parallèle, les tolérances d'alignement des substrats les uns par rapport aux autres rencontrées lors du collage limitent donc la densité d'intégration des composants électroniques pouvant être obtenue dans les circuits électroniques intégrés tridimensionnels ainsi réalisés.

Le document US 2007/0267723 A1 décrit un autre exemple d'une intégration parallèle, où le silicium à l'arrière de deux plaquettes SOI est retiré, et les plaquettes sont ensuite collées dos-à-dos en utilisant les couches d'oxyde enterré. Des contacts sont ensuite formés sur les deux plaquettes, et la plaquette inférieure peut comporter des plots d'atterrissage pour les contacts. Les contacts arrivant sur la plaquette inférieure peuvent être siliciurés.

La deuxième famille, appelée intégration séquentielle, permet de s'affranchir des problèmes d'alignement rencontrés lors d'une intégration parallèle. Lors d'une intégration séquentielle, les différents niveaux de composants électroniques sont réalisés les uns après les autres. Un premier niveau de composants électroniques est par exemple obtenu de manière classique, via la formation des composants électroniques du premier niveau sur un premier substrat par exemple de type SOI (silicium sur isolant) ou massif (ou de type « bulk »). Pour la réalisation des composants électroniques d'un deuxième niveau, une couche de matériau semi-conducteur est soit reportée sur le premier substrat sur lequel les composants électroniques du premier niveau ont été réalisés, comme décrit dans le document FR 2 896 620 ou dans le document US 2008/0054359 A1, soit formée par une épitaxie, ou un dépôt polycristallin recristallisé, de semi-conducteur à travers des ouvertures formées dans un matériau diélectrique protégeant les composants électroniques du premier niveau et permettant de reprendre l'orientation cristalline du semi-conducteur du premier substrat, comme décrit dans les documents US 4 472 729 et US 2009/0020817 A1.

Le document FR 2 896 620 décrit un exemple d'intégration séquentielle dans lequel un assemblage de transistors PMOS sur des transistors NMOS est réalisé en reportant une couche de germanium sur un matériau diélectrique planarisé recouvrant les transistors NMOS qui sont réalisés dans un substrat de silicium. Les transistors PMOS sont ensuite réalisés dans la couche de germanium. L'épaisseur de matériau diélectrique à graver lors de la formation des contacts électriques est environ deux fois plus importante pour le niveau inférieur que pour le niveau supérieur. Or, ceci peut entraîner une dégradation des zones du niveau supérieur destinées à être contactées électriquement (cas d'une sur-gravure), ou bien entraîner une insuffisance de gravure lors de la réalisation des contacts électriques des composants électroniques du niveau inférieur. Pour remédier à cela, il est possible de réaliser les prises de contacts électriques des différents niveaux en plusieurs étapes, ce qui a toutefois pour inconvénient d'augmenter le coût de leur réalisation. De plus, l'interface de collage est située entre les deux niveaux de composants électroniques, ce qui limite les nettoyages à base d'acide fluorhydrique possibles devant être mis en oeuvre lors de la réalisation des transistors (avant le dépôt de l'isolant de grille, après la gravure de la grille, après la ou les gravures du ou des espaceurs, avant les épitaxies des source et drain, et avant la siliciuration des source et drain) en raison du risque de décoller totalement ou partiellement les niveaux de composants électroniques assemblés, ces nettoyages étant nécessaires pour la bonne réalisation et le bon fonctionnement des transistors.

En outre, lors d'une intégration séquentielle telle que décrit ci-dessus, il n'est pas possible d'intégrer des interconnexions électriques locales entre les différents 4 niveaux de composants électroniques en raison des budgets thermiques mis en jeu lors de la réalisation des niveaux supérieurs de composants électroniques (par exemple lors de l'épitaxie des régions de source et de drain des transistors du niveau supérieur qui implique nécessairement des budgets thermiques supérieurs à environ 400°C) qui engendrent une augmentation de la résistance des siliciures (transformation du NiSi en NiSiz) et la destruction par fusion des interconnexions. Des problèmes de contamination des interconnexions électriques reliées aux transistors du niveau inférieur peuvent également apparaître lors du collage de la couche de semi-conducteur du niveau supérieur. Enfin, la réalisation des niveaux supérieurs de composants électroniques doit également se faire avec un budget thermique réduit afin de ne pas dégrader les composants électroniques du niveau inférieur.

Le document FR 2 979 481 décrit un procédé de réalisation d'un circuit électronique intégré tridimensionnel mis en oeuvre à partir d'un empilement tri-couche Si/SiGe/Si réalisé par épitaxie. Les deux couches de silicium servent à la réalisation des zones actives des transistors MOS des deux niveaux du circuit. La couche de SiGe est gravée pour former ensuite une zone d'isolation entre les transistors des deux niveaux. Un tel procédé a pour inconvénient que la distance entre les deux niveaux de transistors est dictée par l'épaisseur initiale de SiGe. Or, pour éviter l'apparition de dislocations, l'épaisseur maximale de SiGe est nécessairement limitée à environ 100 nm ou 150 nm. Or, une telle épaisseur ne permet pas d'insérer d'éléments entre les deux niveaux de transistors, comme par exemple des plans de masse, des interconnexions électriques locales et ou encore un écran thermique et électrostatique.

Le document US 2012/088367 A1 décrit, par exemple dans la figure 47, un procédé comportant la fabrication de transistor MOS séquentielle sur deux côtés, par exemple des transistors PMOS d'un côté et des transistors NMOS de l'autre côté, d'une plaquette SOI. Dans ce procédé, des plaquettes support sont utilisées, et le substrat massif d'origine est retiré. Des interconnexions électriques sont formées à l'aide de contacts formés depuis les deux côtés.

En outre, ces intégrations parallèles ou séquentielles de plusieurs niveaux de composants électroniques se heurtent également à la congestion des niveaux de métallisations qui sont réalisés sur un côté du circuit intégré, ce qui limite la densité avec laquelle les composants électroniques peuvent être réalisés.

### EXPOSÉ DE L'INVENTION

Un but de la présente invention est de proposer un procédé de réalisation d'un circuit électronique intégré tridimensionnel ne présentant pas les inconvénients des procédés de l'art antérieur, c'est-à-dire :
- qui ne présente pas les problèmes d'alignement rencontrés lors d'une intégration parallèle,
- qui ne pose pas de problème de sur-gravure ou d'insuffisance de gravure lors de la réalisation des contacts électriques des composants électroniques,
- qui ne présente pas de problème de contamination des interconnexions électriques,
- qui ne dégrade pas les composants électroniques en raison des budgets thermiques mis en jeu successivement au cours du procédé,
- qui permet l'insertion d'éléments entre deux niveaux de composants électroniques du circuit, comme par exemple des plans de masse, des interconnexions électriques locales et ou encore un écran thermique et électrostatique,
- qui permet la réalisation de niveaux de métallisations sur les côtés, ou faces principales, du circuit.

Pour cela, il est décrit un procédé de réalisation d'un circuit électronique intégré tridimensionnel comportant au moins les étapes spécifiées dans la revendication 1.

Dans ce procédé, l'étape de réalisation de la première portion de matériau électriquement conducteur est mise en oeuvre avant l'étape de réalisation de la deuxième couche diélectrique et de la deuxième couche de semi-conducteur. L'étape de réalisation de la deuxième couche diélectrique et de la deuxième couche de semi-conducteur est mise en oeuvre avant l'étape de réalisation des premier et deuxième composants électroniques. De plus, l'étape de réalisation des premier et deuxième composants électroniques est mise en oeuvre avant l'étape de réalisation de l'interconnexion électrique.

Dans ce procédé, les premier et deuxième composants électroniques sont réalisés séquentiellement, ce qui permet au procédé de s'affranchir des problèmes d'alignement rencontrés lors d'une intégration parallèle.

Les premier et deuxième composants électroniques sont reliés électriquement l'un à l'autre grâce à l'interconnexion électrique locale formée entre eux. Du fait que cette interconnexion électrique est formée de deux parties qui s'étendent chacune depuis l'un des composants électroniques jusqu'à la portion de matériau électriquement conducteur formée préalablement aux composants électroniques, aucun problème de sur-gravure ou d'insuffisance de gravure n'est rencontré lors de la mise en oeuvre de ce procédé.

De plus, du fait que l'interconnexion électrique est formée après la réalisation des premier et deuxième composants électroniques, ce procédé ne pose pas non plus de problème de contamination rencontré notamment lorsqu'un composant électronique d'un niveau supérieur est réalisé en présence d'une interconnexion électrique déjà présente dans le niveau inférieur.

Ce procédé a également pour avantage de ne pas mélanger les budgets thermiques. Dans ce procédé, les étapes dites de « Front-End » impliquant des budgets thermiques importants (par exemple d'environ 1000°C ou plus) sont tout d'abord mises en oeuvre (correspondant par exemple aux étapes allant du début du procédé jusqu'à la fin des étapes d'épitaxie), puis les étapes dites de « Middle-End » (siliciuration, dépôt tungstène, etc.) impliquant des budgets thermiques intermédiaires (par exemple jusqu'à des températures d'environ 500°C) et les étapes dites de « Back-End » (dépôt cuivre, etc.) impliquant des plus faibles budgets thermiques (températures inférieures à environ 400°C) sont mises en oeuvre à la fin du procédé.

Ce procédé a également pour avantage de permettre la réalisation de niveaux de métallisations sur chaque face principale, ou chaque côté, du circuit, repoussant ainsi les limites liées à la congestion des niveaux de métallisations sur un seul côté des circuits intégrés de l'art antérieur, et permet donc d'augmenter la densité des composants électroniques pouvant être réalisés dans le circuit électronique intégré.

Ce procédé permet également d'insérer des plans de masse entre les composants électroniques, ces plans de masse permettant notamment, lorsqu'ils sont couplés aux composants électroniques qui correspondent à des transistors MOS, l'ajustement de la tension de seuil de ces transistors.

Un ou plusieurs niveaux de lignes d'interconnexions électriques locales peuvent être intégrés entre les deux niveaux de composants électroniques, ce qui permet notamment de s'affranchir d'éventuels problèmes d'alignement des contacts traversant (du fait que les interconnexions électriques peuvent être réalisées en deux parties, chacun étant en contact avec un niveau de lignes d'interconnexions électriques), et offrent également la possibilité de connecter les premier et deuxième composants électroniques entre eux sans passer nécessairement par des niveaux de métallisations (niveaux dits de « back-end ») formés sur les côtés du circuit, au-dessus des composants électroniques.

Ce procédé permet également d'insérer un ou plusieurs écrans thermiques et électrostatiques entre les deux niveaux de composants électroniques.

Enfin, dans ce procédé, le design, c'est-à-dire la structure, du ou des premiers composants électroniques est découplé, ou est indépendant, de celui du ou des deuxièmes composants électroniques. Les premier et deuxième composants électroniques ne sont pas nécessairement alignés l'un par rapport à l'autre.

Le premier composant électronique peut être réalisé au niveau d'une face de la deuxième couche de semi-conducteur opposée à celle en contact avec la deuxième couche diélectrique. Le deuxième composant électronique peut être réalisé au niveau d'une face de la première couche de semi-conducteur opposée à celle en contact avec la première couche diélectrique.

Le premier et/ou le deuxième composants électroniques peuvent être des transistors de type MOS. Il est également possible que le premier et/ou le deuxième composants électroniques soient des dispositifs de type MEMS, NEMS ou bien des capteurs de dimensions micrométriques ou nanométriques.

Le procédé peut comporter en outre, avant la réalisation de la première portion de matériau électriquement conducteur, la réalisation d'un premier plan de masse sur la première couche diélectrique, dans lequel la deuxième couche diélectrique peut recouvrir également le premier plan de masse, et dans lequel le deuxième composant électronique peut être réalisé tel qu'une zone active du deuxième composant électronique soit disposée au moins en partie en regard du premier plan de masse. Ainsi, lorsque le deuxième composant électronique correspond à un transistor, ce procédé permet d'insérer entre les deux niveaux de composants électroniques ce premier plan de masse qui permet d'ajuster la tension de seuil du transistor correspondant au deuxième composant électronique.

Le procédé peut comporter en outre, avant la réalisation du premier composant électronique, la réalisation d'un écran thermique et électrostatique dans la deuxième couche diélectrique ou entre les première et deuxième couches diélectriques et tel que l'écran thermique et électrostatique et la première portion de matériau électriquement conducteur soient disposés dans deux niveaux superposés l'un au-dessus de l'autre. Ainsi, ce procédé permet d'insérer entre les deux niveaux de composants électroniques un écran thermique et électrostatique protégeant notamment le premier composant électronique vis-à-vis des étapes mises en oeuvre pour la réalisation du deuxième composant électronique, ou inversement. Il est possible que l'écran thermique et électrostatique soit réalisé après la première portion de matériau électriquement conducteur, l'écran étant dans ce cas disposé dans la deuxième couche diélectrique, ou bien avant la première portion de matériau électriquement conducteur, l'écran étant dans ce cas disposé sur la première couche diélectrique et la première portion de matériau électriquement conducteur étant dans ce cas disposée dans la deuxième couche diélectrique.

Le procédé peut comporter en outre, entre la réalisation de la première portion de matériau électriquement conducteur et la réalisation du premier composant électronique, la réalisation d'une deuxième portion de matériau électriquement conducteur dans la deuxième couche diélectrique telle que les première et deuxième portions de matériau électriquement conducteur soient disposées dans deux niveaux superposés l'un au-dessus de l'autre. Ce procédé permet d'insérer, entre les deux niveaux de composants électroniques, plusieurs niveaux d'interconnexions électriques superposés (la première portion de matériau électriquement conducteur faisant partie d'un premier niveau d'interconnexions électriques et la deuxième portion de matériau électriquement conducteurfaisant partie d'un deuxième niveau d'interconnexions électriques) permettant notamment de former des interconnexions électriques locales reliées aux composants électroniques du circuit électronique intégré.

La première couche diélectrique peut comporter de l'oxyde de semi-conducteur, par exemple du SiOz, et/ou la première portion de matériau électriquement conducteur peut comporter du métal, par exemple du tungstène, et/ou la deuxième couche de semi-conducteur peut être la couche superficielle d'un deuxième substrat SOI et/ou la deuxième couche diélectrique peut comporter de l'oxyde de semi-conducteur, par exemple du SiO₂, et/ou l'interconnexion électrique peut comporter du métal, par exemple du tungstène, et/ou la première couche de semi-conducteur peut comporter un semi-conducteur monocristallin, par exemple du silicium monocristallin et/ou la deuxième couche de semi-conducteur peut comporter un semi-conducteur monocristallin, par exemple du silicium monocristallin. L'utilisation de semi-conducteur monocristallin a notamment pour avantage de réaliser des composants électroniques à hautes performances et faible consommation.

Plusieurs premiers composants électroniques pouvant correspondre à des premiers transistors NMOS et PMOS peuvent être réalisés dans la deuxième couche de semi-conducteur, et plusieurs deuxièmes composants électroniques pouvant correspondre à des deuxièmes transistors NMOS et PMOS peuvent être réalisés dans la première couche de semi-conducteur. Dans cette configuration, les zones actives des transistors PMOS et NMOS d'un même niveau de composants électroniques peuvent comporter un semi-conducteur de même nature, par exemple du silicium.

En variante, le procédé peut comporter en outre, avant la réalisation de la première portion de matériau électriquement conducteur, la réalisation d'une troisième couche de semi-conducteur sur la première couche de semi-conducteur, le matériau de la troisième couche de semi-conducteur pouvant être différent du matériau de la première couche de semi-conducteur, et telle que la première couche diélectrique peut recouvrir la troisième couche de semi-conducteur, et plusieurs deuxièmes composants électroniques pouvant correspondre à des deuxièmes transistors NMOS et PMOS peuvent être réalisés tels que les zones actives des deuxièmes transistors NMOS soient réalisées dans la première couche de semi-conducteur et tels que les zones actives des deuxièmes transistors PMOS soient réalisées dans la troisième couche de semi-conducteur. Ainsi, il est possible d'utiliser des matériaux semi-conducteurs différents pour la réalisation des deuxièmes transistors NMOS et PMOS, par exemple du silicium pour la réalisation des deuxièmes transistors NMOS et du SiGe pour la réalisation des deuxièmes transistors PMOS.

Le procédé peut comporter en outre, entre la réalisation de la première portion de matériau électriquement conducteur et la réalisation du premier composant électronique, la réalisation d'une quatrième couche de semi-conducteur disposée entre la deuxième couche diélectrique et la deuxième couche de semi-conducteur, le matériau de la quatrième couche de semi-conducteur pouvant être différent du matériau de la deuxième couche de semi-conducteur, et plusieurs premiers composants électroniques pouvant correspondre à des premiers transistors NMOS et PMOS peuvent être réalisés tels que les zones actives des premiers transistors NMOS soient réalisées dans la deuxième couche de semi-conducteur et tels que les zones actives des premiers transistors PMOS soient réalisées dans la quatrième couche de semi-conducteur. Ainsi, il est possible d'utiliser des matériaux semi-conducteurs différents pour la réalisation des premiers transistors NMOS et PMOS, par exemple du silicium pour la réalisation des premiers transistors NMOS et du SiGe pour la réalisation des premiers transistors PMOS.

La première couche de semi-conducteur peut être la couche superficielle d'un premier substrat SOI, et la couche massive et la couche diélectrique enterrée du premier substrat SOI peuvent être désolidarisées de la première couche de semi-conducteur après la réalisation du premier composant électronique et avant la réalisation du deuxième composant électronique.

Le premier contact peut être réalisée en gravant au moins un premier trou à travers la première couche diélectrique et en remplissant le premier trou d'un matériau électriquement conducteur, puis le deuxième contact peut être réalisée en gravant au moins un deuxième trou à travers au moins une partie de la deuxième couche diélectrique et en remplissant le deuxième trou du matériau électriquement conducteur.

Dans ce cas, le procédé peut comporter en outre, après la réalisation du premier contact, la réalisation d'un ou plusieurs premiers niveaux de métallisations sur le deuxième composant électronique, et peut comporter en outre, après la réalisation du deuxième contact, la réalisation d'un ou plusieurs deuxièmes niveaux de métallisations sur le premier composant électronique.

Le deuxième composant électronique peut être disposé entre la deuxième couche de semi-conducteur et le ou les premiers niveaux de métallisations. Le premier composant électronique peut être disposé entre la première couche de semi-conducteur et le ou les deuxièmes niveaux de métallisations. Les composants électroniques peuvent être disposés entre les premiers et deuxièmes niveaux de métallisations.

La ou les interconnexions formées entre les deux niveaux de composants électroniques peuvent connecter directement deux composants électroniques, ou bien réaliser un shunt, ou une dérivation, ou être reprises par les niveaux de métallisations.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :

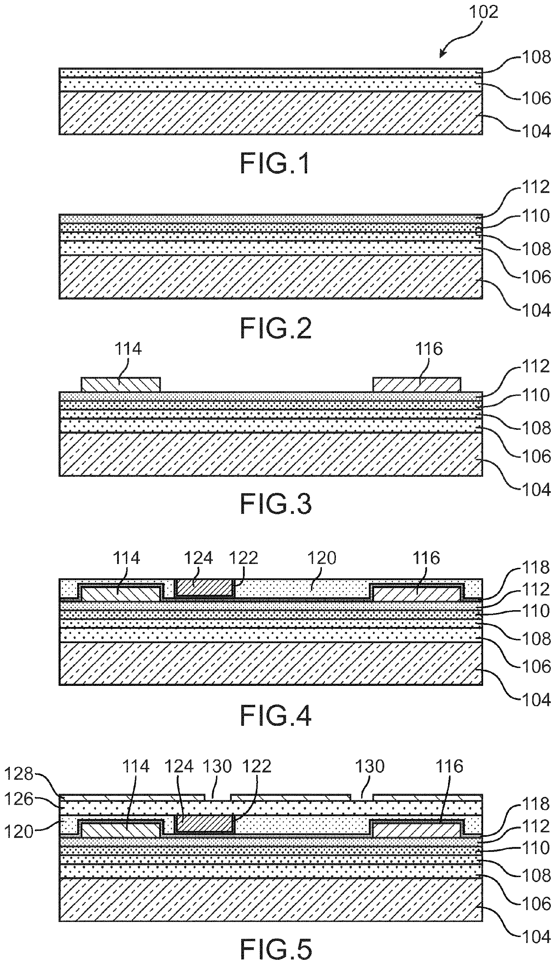

- les figures 1 à 16 représentent les étapes d'un procédé de réalisation d'un circuit électronique intégré tridimensionnel, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Les figures 1 à 16 représentent les étapes d'un procédé de réalisation d'un circuit électronique intégré tridimensionnel 100 selon un mode de réalisation particulier. Sur les figures 1 à 16, seule une partie du circuit 100 dans laquelle deux premiers et deux deuxièmes composants électroniques sont réalisés est représentée selon des vues en coupe de côté. Toutefois, le circuit 100 peut comporter un nombre plus important de premiers composants électroniques réalisés sur le premier niveau de composants électroniques et/ou un nombre plus important de deuxièmes composants électroniques réalisés sur le deuxième niveau de composants électroniques.

Comme représenté sur la figure 1, le circuit 100 est réalisé à partir d'un premier substrat 102 de type SOI comportant une couche massive 104 de semi-conducteur, une couche diélectrique enterrée 106 (également BOX ou « buried oxide ») et une couche superficielle 108 de semi-conducteur. Dans le mode de réalisation décrit ici, la couche massive 104 comporte du silicium et une épaisseur égale à plusieurs centaines de microns, la couche diélectrique enterrée 106 comporte du SiOz et une épaisseur par exemple comprise entre environ 10 nm et 3 µm, et la couche superficielle 108 comporte du silicium et une épaisseur inférieure à environ 10 µm et avantageusement inférieure à environ 100 nm (cette épaisseur étant avantageusement ajustée à l'épaisseur nécessaire pour la réalisation des zones actives de transistors NMOS). En variante, le premier substrat 102 pourrait être un substrat massif de semi-conducteur ou encore un substrat de type autre que SOI.

La couche superficielle 108 est destinée à se trouver au niveau d'un deuxième côté du circuit 100 au niveau duquel vont être réalisés des deuxièmes composants électroniques, par exemple des deuxièmes transistors PMOS et des deuxièmes transistors NMOS. Le circuit 100 comporte également un premier côté, opposé au deuxième côté, au niveau duquel vont être réalisés des premiers composants électroniques, par exemples des premiers transistors PMOS et des premiers transistors NMOS, dans une autre couche de semi-conducteur.

Comme représenté sur la figure 2, une couche 110 comportant un semi-conducteur différent de celui de la couche superficielle 108 est réalisée sur la couche superficielle 108. Dans le mode de réalisation décrit ici, la couche 110 est réalisée du fait que des deuxièmes transistors MOS de conductivités différentes (NMOS et PMOS) sont destinés à être réalisés au niveau du deuxième côté du circuit 100 où se trouvent les couches semi-conductrices 108 et 110, le semi-conducteur de la couche 110 étant adapté à la réalisation des zones actives des deuxièmes transistors d'un premier type de conductivité (par exemple PMOS) et le semi-conducteur de la couche superficielle 108 est adapté à la réalisation des zones actives des deuxièmes transistors du second type de conductivité (par exemple NMOS). La couche 110 correspond ici à une couche de SiGe réalisée par épitaxie, comportant une proportion de germanium comprise entre environ 5 % et 50 % et une épaisseur comprise entre environ 5 nm et 20 nm.

En variante, il est possible que cette couche 110 ne soit pas réalisée, par exemple si les deuxièmes composants électroniques ne nécessitent pas d'être réalisés à partir de deux semi-conducteurs différents (transistors MOS de même conductivité, ou transistors NMOS et PMOS réalisés uniquement à partir du semi-conducteur de la couche superficielle 108, ou composants électroniques autres que des transistors MOS réalisés uniquement à partir du semi-conducteur de la couche superficielle 108).

Une couche diélectrique 112 est réalisée ensuite sur la couche 110 (ou sur la couche superficielle 108 si la couche 110 est omise). La couche 112 comporte par exemple du SiO₂ réalisé par une oxydation à haute température (HTO), par exemple entre environ 600°C et 850°C. La couche 112 peut correspondre également à un empilement de plusieurs couches diélectriques, par exemple un empilement d'une première couche de SiOz, d'une deuxième couche de SiN et d'une troisième couche de SiO₂. L'épaisseur de la couche 112 est par exemple comprise entre environ 5 nm et 15 nm. En variante, il est possible que la couche 110 soit recouverte d'un dépôt très fin de silicium formé par épitaxie, préalablement à la réalisation de la couche diélectrique 112, afin d'éviter un enrichissement en germanium de la couche 110 par l'oxydation ensuite mise en oeuvre.

De manière avantageuse, une couche de matériau compressif, par exemple du SiN, peut être interposée entre les couches 110 et 112 afin d'induire une contrainte dans le semi-conducteur de la couche 110, ce qui permet de favoriser la mobilité des trous dans ce semi-conducteur. Dans le mode de réalisation particulier décrit ici, cette couche de matériau compressif permet d'optimiser le fonctionnement des deuxièmes transistors PMOS dont les zones actives seront formées dans la couche 110. Cette couche de matériau compressif n'est pas visible sur la figure 2. Si la couche 110 est omise, la couche de matériau compressif peut être disposée entre les couches 108 et 112, et induire ainsi une contrainte dans le semi-conducteur de la couche superficielle 108.

Il est également possible d'utiliser à la fois un matériau induisant une contrainte en tension dans le ou les deuxièmes transistors NMOS, et un matériau induisant une contrainte en compression dans le ou les deuxièmes transistors PMOS. Par exemple, le matériau induisant la contrainte en tension est tout d'abord déposé, puis une lithographie, une gravure et un retrait sont mis en oeuvre afin de conserver ce matériau au niveau des zones actives des transistors NMOS. Le matériau induisant une contrainte en compression est ensuite déposé. Une lithographie, une gravure et un retrait sont mis en oeuvre afin de conserver ce matériau au niveau des zones actives des transistors PMOS. Les deux gravures mises en oeuvre sont stoppées à la surface du semi-conducteur. Ces matériaux s'insèrent entre les semi-conducteurs (N et P) et les plans de masse des transistors destinés à être réalisés.

Des plans de masse 114 et 116 (destinés à être couplés aux deuxièmes transistors PMOS et NMOS) sont ensuite réalisés sur la couche diélectrique 112 (figure 3). Pour cela, un dépôt d'une couche de matériau électriquement conducteur, ici du polysilicium, est déposée sur la couche diélectrique 112. Une lithographie et une gravure de cette couche de matériau électriquement conducteur sont ensuite mises en oeuvre afin que les portions restantes de cette couche électriquement conductrice soient destinées à former les plans de masse 114, 116. Des étapes de lithographie et d'implantation de dopants de type N et P (selon la conductivité des transistors destinés à être couplés à ces plans de masse) dans les portions restantes de la couche électriquement conductrice sont ensuite mises en oeuvre. Les plans de masse 114 et 116 réalisés ont par exemple une épaisseur comprise entre environ 10 nm et 20 nm.

La réalisation de ces plans de masse 114, 116 peut être omise si les deuxièmes composants électroniques ne nécessitent pas de tels plans de masse (par exemple dans le cas de deuxièmes composants électroniques ne correspondant pas à des transistors CMOS à tensions de seuil ajustables).

A ce stade du procédé, un premier niveau d'interconnexions électriques destiné à former une partie des interconnexions électriques locales et à être disposé entre les premiers et deuxièmes composants électroniques se trouvant de chaque côté du circuit 100 est réalisé. Ces interconnexions électriques locales sont destinées à relier électriquement l'un des premiers composants électroniques à l'un des deuxièmes composants électroniques et/ou à relier électriquement des composants électroniques se trouvant sur un même côté du circuit 100 (par exemple deux premiers composants électroniques ou deux deuxièmes composants électroniques).

Pour cela, une couche d'arrêt de gravure 118, comportant un matériau diélectrique tel que du SiN, est déposée sur la couche diélectrique 112 et recouvre également les plans de masse 114 et 116. La couche d'arrêt de gravure 118 est par exemple déposée de manière conforme sur la couche diélectrique 112 et les plans de masse 114, 116 avec une épaisseur comprise entre environ 5 nm et 10 nm. Une couche de SiO₂ d'épaisseur par exemple comprise entre environ 20 nm et 40 nm peut être déposée préalablement au dépôt de cette couche de SiN.

Une autre couche diélectrique 120, comportant par exemple du SiO₂, est ensuite déposée sur la couche d'arrêt de gravure 118, puis planarisée par exemple par CMP (planarisation mécano-chimique) telle que la couche diélectrique 120 ait une épaisseur finale comprise entre environ 40 nm et 80 nm.

Des étapes de lithographie et gravure (avec arrêt sur la couche d'arrêt de gravure 118) sont ensuite mises en oeuvre afin de former à travers la couche diélectrique 120 des ouvertures destinées à former des emplacements pour la réalisation de portions 124 de matériau électriquement conducteur formant le premier niveau d'interconnexions électriques. Dans le mode de réalisation décrit ici, une seule ouverture est réalisée dans la couche diélectrique 120.

Une couche barrière 122, par exemple de type Ti/TiN et d'épaisseur comprise entre environ 3 nm et 7 nm, est ensuite déposée de manière conforme sur la couche diélectrique 120 ainsi que dans les ouvertures précédemment réalisées à travers la couche diélectrique 120, recouvrant ainsi les parois latérales et la paroi de fond de ces ouvertures.

Une couche de matériau électriquement conducteur, comportant par exemple du tungstène et d'épaisseur comprise entre environ 40 nm et 80 nm, est ensuite déposée sur la couche barrière 122 et telle que les ouvertures formées dans la couche diélectrique 120 soient remplies parce matériau électriquement conducteur. Cette couche de tungstène est par exemple formée par un dépôt CVD réalisé avec du WF₆. La couche barrière 122 forme une couche d'accroche pour le dépôt de cette couche conductrice et permet également de limiter la diffusion de fluor engendré par le dépôt de tungstène dans les matériaux se trouvant sous la couche barrière 122.

La réalisation des portions 124 de matériau électriquement conducteur destinées à former le premier niveau d'interconnexions électriques est ensuite achevée par une planarisation éliminant le matériau électriquement conducteur présent hors des ouvertures. Cette planarisation est réalisée soit avec un arrêt sur la couche diélectrique 120, soit avec arrêt sur les portions de la couche d'arrêt de gravure 118 qui recouvrent les plans de masse 114, 116.

La structure obtenue à ce stade du procédé est représentée sur la figure 4. Sur cette figure, une seule portion 124 de matériau électriquement conducteur destinée à faire partie d'une interconnexion électrique locale est représentée.

A la différence de ce qui est réalisé usuellement lors d'une intégration séquentielle, les séquences d'alignements lithographiques mises en oeuvre sont ici modifiées, les niveaux de référence d'alignement n'étant plus ceux formés par les zones actives ou les grilles des transistors, mais ceux formés par les plans de masse ou encore par le ou les niveaux d'interconnexions électriques destinés à relier les transistors entre eux. Les premier et deuxième composants électroniques pourront donc être réalisés alignés ou non les uns par rapport aux autres.

A ce stade du procédé, il est possible de réaliser un écran thermique et électrostatique dont le rôle est de limiter les éventuels impacts du budget thermique lié à la réalisation des deuxièmes composants électroniques vis-à-vis des premiers composants électroniques qui seront réalisés avant les deuxièmes composants électroniques.

Ainsi, comme représenté sur la figure 5, une couche diélectrique 126 est déposée sur la structure précédemment obtenue, c'est-à-dire sur la couche diélectrique 120 et sur la portion conductrice 124 (et éventuellement sur les parties de la couche d'arrêt de gravure 118 recouvrant les plans de masse 114, 116 si la précédente planarisation a été réalisée avec un arrêt sur ces parties de la couche d'arrêt de gravure 118). Cette couche diélectrique 126 correspond par exemple à une couche de SiOz ou une couche de SiN, ou encore à un empilement d'une couche de SiO₂ et d'une couche de SiN, et comporte une épaisseur par exemple comprise entre environ 5 nm et 10 nm.

Une couche écran 128 destinée à former l'écran thermique et électrostatique est ensuite déposée sur la couche diélectrique 126. Cette couche écran 128 comporte par exemple de l'Al₂O₃, du polysilicium dopé, un alliage de silicium et de titane, un empilement Ti/TiN et tungstène, ou encore un empilement de plusieurs de ces matériaux. L'épaisseur de la couche écran 128 est par exemple comprise entre environ 5 nm et 10 nm. Des ouvertures 130 peuvent être réalisées à travers la couche écran 128 de manière à permettre le passage des futures interconnexions électriques locales du circuit 100.

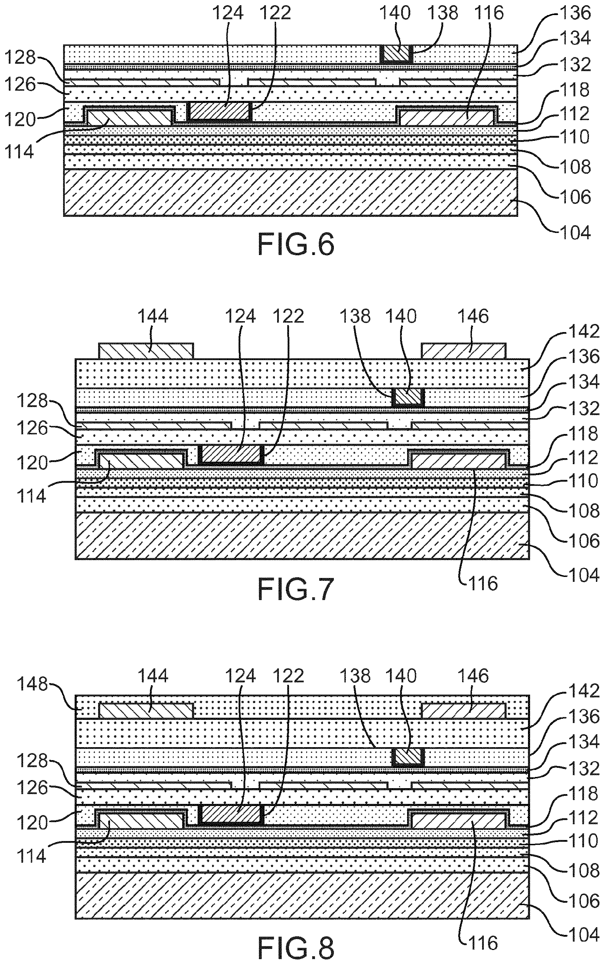

Une couche diélectrique 132, comportant par exemple du SiO₂, est ensuite déposée sur la couche écran 128 et dans les éventuelles ouvertures 130 formées à travers la couche écran 128 (voir figure 6). Cette couche diélectrique 132 est ensuite planarisée telle que son épaisseur soit par exemple comprise entre environ 5 nm et 20 nm.

En variante, la réalisation de cet écran thermique et électrostatique peut être omise.

Il est possible de réaliser un deuxième niveau d'interconnexions électriques destiné à être disposé entre les premier et deuxième composants électroniques se trouvant de chaque côté du circuit 100. Comme pour le premier niveau formé par la ou les portions 124, les éléments conducteurs du deuxième niveau d'interconnexions électriques sont destinés à relier électriquement un premier composant électronique à un deuxième composant électronique et/ou des composants électroniques se trouvant sur un même côté du circuit 100.

Pour cela, une couche d'arrêt de gravure 134, comportant un matériau diélectrique tel que du SiN et une épaisseur comprise entre environ 5 nm et 10 nm, est ensuite déposée sur la couche diélectrique 132.

Une autre couche diélectrique 136, comportant par exemple du SiOz et une épaisseur comprise entre environ 20 nm et 40 nm, est ensuite déposée sur la couche d'arrêt de gravure 134.

Des étapes de lithographie et gravure (avec arrêt sur la couche d'arrêt de gravure 134) sont ensuite mises en oeuvre afin de former à travers la couche diélectrique 136 des ouvertures destinées à former des emplacements pour la réalisation de portions 140 de matériau électriquement conducteur destinées à former le deuxième niveau d'interconnexions électriques. Dans le mode de réalisation décrit ici, une seule ouverture est réalisée dans la couche diélectrique 136.

Une couche barrière 138, par exemple de type Ti/TiN et d'épaisseur comprise entre environ 3 nm et 7 nm, est ensuite déposée de manière conforme sur la couche diélectrique 136 ainsi que dans les ouvertures précédemment réalisées à travers la couche diélectrique 136, recouvrant ainsi les parois latérales et la paroi de fond de ces ouvertures.

Une couche de matériau électriquement conducteur, comportant par exemple du tungstène et d'épaisseur comprise entre environ 20 nm et 40 nm, est ensuite déposée sur la couche barrière 138 et telle que les ouvertures formées dans la couche diélectrique 136 soient remplies parce matériau électriquement conducteur. Cette couche de tungstène est par exemple formée par un dépôt CVD réalisé avec du WF₆. La couche barrière 138 forme une couche d'accroche pour le dépôt de cette couche conductrice et permet également de limiter la diffusion de fluor engendré par le dépôt de tungstène dans les matériaux se trouvant sous la couche barrière 138.

La réalisation des portions 140 de matériau électriquement conducteur est ensuite achevée par une planarisation, par exemple une CMP, éliminant le matériau électriquement conducteur présent en dehors des ouvertures. Cette planarisation est réalisée avec un arrêt sur la couche diélectrique 136.

La structure obtenue à ce stade du procédé est représentée sur la figure 6. Sur cette figure, une seule portion 140 de matériau électriquement conducteur destinée à faire partie du deuxième niveau d'interconnexions électriques est représentée.

Dans le procédé décrit ici, deux niveaux d'interconnexions électriques sont réalisés. En variante, il est possible que seul l'un de ces deux niveaux soit réalisé. Il est également possible de réaliser plus de deux niveaux d'interconnexions électriques, en espaçant ces différents niveaux par une couche de matériau diélectrique.

Une couche diélectrique 142, comportant par exemple du SiO₂, est ensuite déposée en recouvrant la couche diélectrique 136 ainsi que les portions 140 de matériau électriquement conducteur.

Des plans de masse 144 et 146 (destinés à être couplés aux premiers transistors PMOS et NMOS) sont ensuite réalisés sur la couche diélectrique 142 (figure 7). Pour cela, un dépôt d'une couche de matériau électriquement conducteur, ici du polysilicium, est déposée sur la couche diélectrique 142. Une lithographie et une gravure de cette couche conductrice sont ensuite mises en oeuvre afin que les portions restantes de cette couche conductrice soient destinées à former les plans de masse 144, 146. Des étapes de lithographie et d'implantation de dopants dans les portions restantes sont ensuite mises en oeuvre. Les plans de masse 144 et 146 réalisés ont par exemple une épaisseur comprise entre environ 10 nm et 20 nm.

La réalisation de ces plans de masse 144, 146 peut être omise si les premiers composants électroniques ne nécessitent pas de tels plans de masse.

Une couche de semi-conducteur destinée à la réalisation des premiers composants électroniques va ensuite être formée, par exemple par collage, sur la structure précédemment réalisée. Pour préparer ce collage, une couche diélectrique 148, comportant par exemple du SiO₂, est déposée sur la couche diélectrique 142 et recouvre également les plans de masse 144, 146. La couche diélectrique 148 est ensuite planarisée.

La couche de semi-conducteur destinée à la réalisation des premiers composants électroniques correspond à la couche superficielle d'un deuxième substrat 150 de type SOI comportant une couche massive 152 de semi-conducteur, une couche diélectrique enterrée 154 et la couche superficielle 156 de semi-conducteur. Dans le mode de réalisation décrit ici, la couche massive 152 comporte du silicium, la couche diélectrique 154 comporte du SiO₂ d'épaisseur comprise entre environ 10 nm et 3 µm, et la couche superficielle 156 comporte du silicium d'épaisseur inférieure à environ 10 µm et avantageusement inférieure à environ 100 nm (épaisseur ajustée selon l'épaisseur nécessaire pour la réalisation des premiers transistors de type NMOS). En variante, le premier substrat 150 pourrait être un substrat massif de semi-conducteur ou encore un substrat de type autre que SOI.

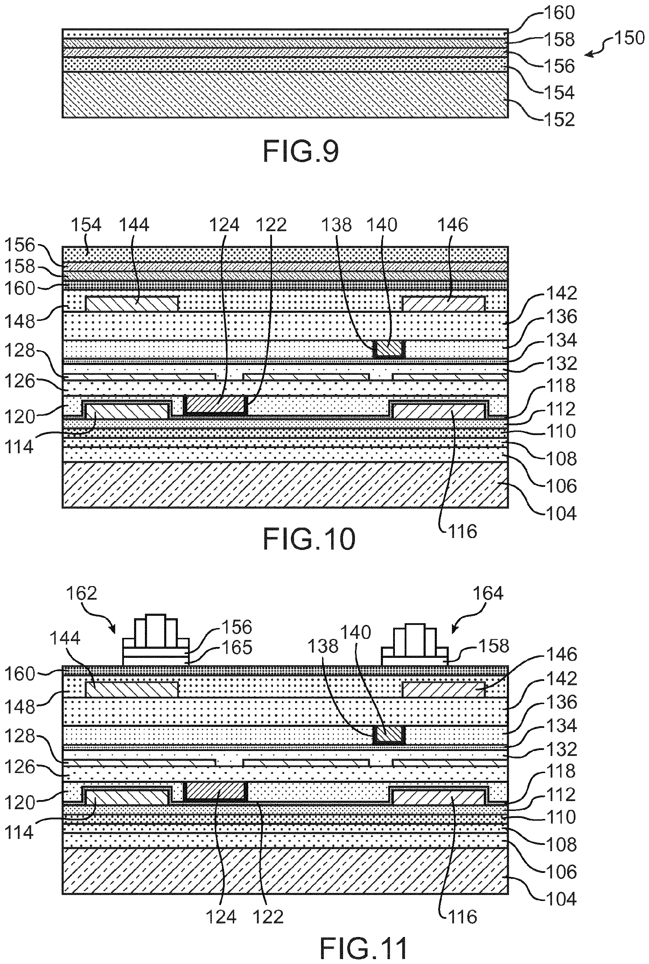

Comme représenté sur la figure 9, une couche 158 comportant un semi-conducteur différent de celui de la couche superficielle 156 est réalisée sur la couche superficielle 156. Dans le mode de réalisation décrit ici, la couche 158 est réalisée du fait que des premiers transistors MOS de conductivités différentes sont destinés à être réalisés au niveau du premier côté du circuit 100, le semi-conducteur de la couche 158 étant adapté à la réalisation des zones actives des premiers transistors d'un premier type de conductivité (par exemple PMOS) et le semi-conducteur de la couche superficielle 156 est adapté à la réalisation des zones actives des premiers transistors du second type de conductivité (par exemple NMOS). La couche 158 correspond ici à une couche de SiGe réalisée par épitaxie, comportant une proportion de germanium comprise entre environ 5 % et 50 % et une épaisseur comprise entre environ 5 nm et 20 nm.

En variante, il est possible que cette couche 158 ne soit pas réalisée, par exemple si les premiers composants électroniques ne nécessitent pas un semi-conducteur différent de celui de la couche superficielle 156 (transistors MOS de même conductivité, ou transistors NMOS et PMOS réalisés uniquement à partir du semi-conducteur de la couche superficielle 156, ou composants électroniques autres que des transistors MOS).

Une couche diélectrique 160 est réalisée ensuite sur la couche 158 (ou sur la couche superficielle 156 si la couche 158 est omise). La couche 160 comporte par exemple du SiO₂ réalisé par HTO. La couche 160 peut correspondre également à un empilement de plusieurs couches diélectriques, par exemple un empilement d'une première couche de SiO₂, d'une deuxième couche de SiN et d'une troisième couche de SiO₂. L'épaisseur de la couche diélectrique 160 est par exemple comprise entre environ 5 nm et 15 nm.

De manière avantageuse, une couche de matériau compressif, par exemple du SiN, peut être interposée entre les couches 158 et 160 afin d'induire une contrainte dans le semi-conducteur de la couche 158, ce qui permet de favoriser la mobilité des trous dans ce semi-conducteur. Dans le mode de réalisation particulier décrit ici, cette couche de matériau compressif permet d'optimiser le fonctionnement des premiers transistors PMOS dont les zones actives seront formées dans la couche 158. Cette couche de matériau compressif n'est pas visible sur la figure 9. Si la couche 158 est omise, la couche de matériau compressif peut être disposée entre les couches 156 et 160, et induire ainsi une contrainte dans le semi-conducteur de la couche superficielle 156.

Il est également possible que du matériau induisant une contrainte en tension et du matériau induisant une contrainte en compression soient formés pour les premiers transistors, comme précédemment décrit pour les deuxièmes transistors.

Le deuxième substrat 150 est reporté et collé tel que la couche diélectrique 160 soit disposée contre la couche diélectrique 148, par exemple par collage direct (également appelé collage moléculaire) SiO₂ - SiO₂ (figure 10).

Un recuit de densification de ce collage peut être réalisé ici dans les meilleures conditions puisque les matériaux en présence sont tous compatibles avec des températures relativement élevées (±800°c).

La couche massive 152 du deuxième substrat 150 est éliminée par exemple par abrasion mécanique et gravure chimique (via une solution de TMAH), la couche diélectrique enterrée 154 pouvant servir de couche d'arrêt à cette gravure. La couche diélectrique enterrée 154 est ensuite retirée, par exemple par une gravure chimique faisant appel à une solution de HF.

La structure obtenue à ce stade du procédé comporte donc une première couche de semi-conducteur 108 et une deuxième couche de semi-conducteur 156 entre lesquelles se trouvent notamment :
- une première couche diélectrique 112 ;
- plusieurs couches diélectriques 118, 120, 126, 132, 134, 136, 142, 148 et 160, dont les couches 126, 132, 134, 136, 142, 148 et 160 recouvrent la ou les portions 124 de matériau électriquement conducteur et peuvent être considérées comme formant ensemble une deuxième couche diélectrique ;
- deux niveaux d'interconnexions électriques 124, 140 disposés dans la deuxième couche diélectrique ;
- des premiers plans de masse 114, 116 disposés sur la première couche diélectrique et recouverts par la deuxième couche diélectrique ;
- des deuxièmes plans de masse 144, 146 disposés dans la deuxième couche diélectrique ;
- un écran thermique et électrostatique 128 disposé dans la deuxième couche diélectrique.

Comme représenté sur la figure 11, les premiers composants électroniques, ici des premiers transistors NMOS 162 et des premiers transistors PMOS 164, sont réalisés dans les couches actives 156 et 158 issues du deuxième substrat 150, via des étapes correspondant à celles classiquement mises en oeuvre pour la réalisation de transistors CMOS. Les premiers transistors PMOS 164 peuvent être réalisés en gravant les parties de la couche superficielle 156 localisées au niveau de ces transistors du fait que les zones actives des premiers transistors PMOS 164 sont formées par des parties de la couche 158 de SiGe. Pour la réalisation des premiers transistors NMOS 162, après la réalisation de la grille et des espaceurs de cette couche et en ayant gravé les couches 156 et 158 pour former les zones actives des premiers transistors NMOS 162, les parties de la couche 158 de SiGe localisées sous les zones actives des premiers transistors NMOS 162 (qui sont formées par des parties de la couche superficielle 156 de silicium) ainsi que les éventuelles parties de la couche de matériau compressif localisées sous les zones actives des premiers transistors NMOS 162 peuvent être éliminées, par exemple par une gravure sèche isotrope et après avoir masqué les premiers transistors PMOS pour protéger les zones actives de ces transistors vis-vis de la gravure mise en oeuvre, puis remplacées par un dépôt conforme d'oxyde (SiO₂) de type HTO ou d'un nitrure (SiN) référencé 165. Les portions de ces matériaux qui recouvrent les premiers transistors PMOS 164 peuvent être gravées, en ayant au préalable masqué les premiers transistors NMOS 162.

Le matériau 165 choisi pour remplacer le matériau de la couche 158 sous les zones actives des premiers transistors NMOS 162 est avantageusement un matériau apte à mettre le matériau des zones actives des premiers transistors NMOS 162 en tension afin de favoriser la mobilité des électrons de ces transistors, comme par exemple du nitrure.

Un oxyde de protection présent en surface des zones de source et de drain des premiers transistors 162, 164 et masquant les zones destinées à ne pas être épitaxiées, est éliminé séquentiellement pour mettre en oeuvre les épitaxies nécessaires à la réalisation des régions de source et de drain des premiers transistors 162, 164.

Les matériaux en présence permettent l'utilisation de procédés à hautes températures (>650°c) ce qui est favorable à la faisabilité et la qualité des premiers composants électroniques.

Les premiers composants électroniques 162, 164 sont ensuite recouverts d'une couche diélectrique 166, comportant par exemple du SiOz et une épaisseur comprise entre environ 100 nm et plusieurs centaines de nanomètres, par exemple 300 nm, déposée et planarisée. Cette couche diélectrique 166 peut recouvrir les premiers transistors 162, 164 alors que des siliciurations des contacts de ces premiers transistors 162, 164 n'ont pas été réalisées, ce siliciure étant sensible aux budgets thermiques mis en jeu.

En variante, les premiers transistors 162, 164 peuvent être réalisés selon un procédé dit « gate last », c'est-à-dire en réalisant les grilles de ces transistors après les autres éléments de ces transistors. Dans cette variante, le matériau remplaçant le matériau de la couche 158 sous les zones actives des transistors NMOS 162 est déposé. De l'oxyde (TEOS) est ensuite déposé. Les transistors NMOS 162 sont ensuite masqués puis les matériaux précédemment déposés se trouvant sur les transistors PMOS 164 sont ensuite retirés par exemple par gravure. Un matériau compressif, tel que du nitrure déposé par PECVD (par exemple SiN) et une couche d'oxyde TEOS d'épaisseur comprise entre environ 20 nm et 40 nm, est ensuite déposé pour les transistors PMOS 164. Les transistors PMOS 164 sont ensuite masqués puis le matériau compressif se trouvant sur les transistors NMOS 162 est ensuite retiré par exemple par gravure. Un matériau de contrainte en tension, comportant par exemple du nitrure déposé par PECVD, tel que du SiN, est ensuite déposé et gravé afin d'être localisé sur les transistors NMOS 162. Un matériau diélectrique, par exemple du SiOz, formant une partie de la couche diélectrique 166 est ensuite déposé en recouvrant les premiers transistors 162, 164, puis planarisé avec arrêt sur les grilles temporaires, comportant par exemple du silicium polycristallin ou du silicium amorphe pour la grille et du SiO₂ pour le diélectrique de grille, avec lesquelles les premiers transistors 162, 164 ont été réalisés. Ces grilles temporaires sont ensuite retirées, par exemple par une gravure sèche. Un diélectrique de grille à forte permittivité (High-K) et un métal de grille sont ensuite déposés pour former les diélectriques de grille et les grilles des premiers transistors 162, 164. Une planarisation est ensuite mise en oeuvre pour supprimer le métal déposé en excès. La couche diélectrique 166 est ensuite achevée en déposant de nouveau un matériau diélectrique.

Les métaux des grilles des transistors peuvent être différents selon le type N ou P des transistors. Dans ce cas, une différence de hauteur entre les transistors NMOS 162 et PMOS 164, comme c'est le cas dans l'exemple décrit ici du fait que les zones actives de ces transistors sont réalisées à partie de couches semi-conductrices différentes et superposées, peut être un atout pour intégrer ces métaux de grille différents.

Si le matériau de la couche diélectrique 166 est destiné à être complètement retiré ultérieurement, notamment pour réaliser des contacts auto-alignés sur les sources et drains des transistors, il peut être judicieux de déposer une couche d'arrêt, comportant par exemple du nitrure tel que du SiN, ou encore du HfO₂, préalablement au dépôt de la couche diélectrique 166.

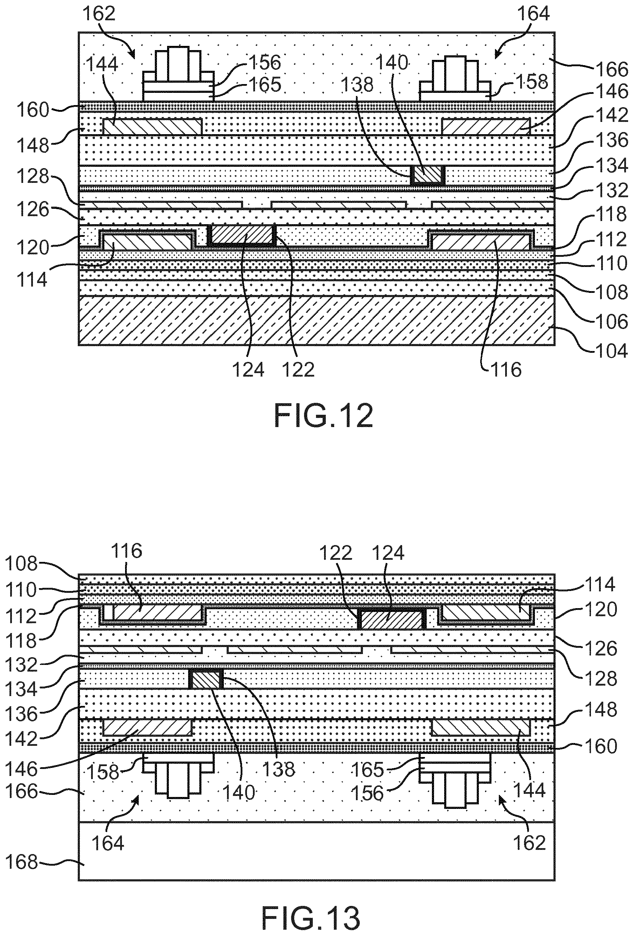

Comme représenté sur la figure 13, la structure obtenue est ensuite retournée et la couche diélectrique 166 est solidarisée à un troisième substrat 168 correspondant par exemple à un substrat massif de silicium oxydé permettant une solidarisation par un collage direct oxyde - oxyde avec la couche diélectrique 166. Ce collage étant temporaire, il n'est pas nécessaire de le densifier par un recuit.

La couche massive 104 et la couche diélectrique enterrée 106 issues du premier substrat 102 sont ensuite retirées, par exemple par abrasion mécanique puis chimique (avec une solution de TMAH) pour la couche massive 104, et par gravure chimique (avec une solution de HF à 1 % ou 0.1 %) pour la couche diélectrique enterrée 106.

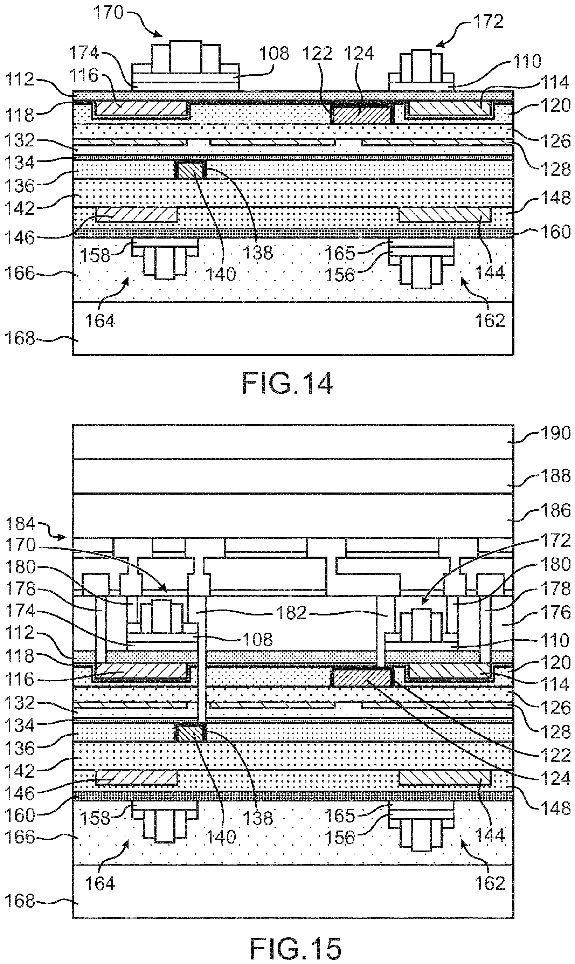

Comme représenté sur la figure 14, les deuxièmes composants électroniques, ici des deuxièmes transistors NMOS 170 et des deuxièmes transistors PMOS 172, sont réalisés dans les couches actives 108 et 110 issues du premier substrat 102, via des étapes correspondant à celles classiquement mises en oeuvre pour la réalisation de transistors CMOS. Les deuxièmes transistors PMOS 172 peuvent être réalisés en gravant les parties de la couche superficielle 108 localisées au niveau de ces transistors du fait que les zones actives des deuxièmes transistors PMOS 172 sont formées par des parties de la couche 110 de SiGe. Pour la réalisation des deuxièmes transistors NMOS 170, après la réalisation de la grille et des espaceurs de cette couche et en ayant gravé les couches 108 et 110 pour former les zones actives des deuxièmes transistors NMOS 170, les parties de la couche 110 de SiGe localisées sous les zones actives des deuxièmes transistors NMOS 170 (qui sont formées par des parties de la couche superficielle 108 de silicium) ainsi que les éventuelles parties de la couche de matériau compressif localisées sous les zones actives des deuxièmes transistors NMOS 170 peuvent être éliminées, par exemple par une gravure sèche isotrope et après avoir masqué les deuxièmes transistors PMOS 172 pour protéger les zones actives de ces transistors vis-à-vis de la gravure mise en oeuvre, puis remplacées par un dépôt conforme d'oxyde (SiO₂) de type HTO ou d'un nitrure (SiN) référencé 174. Les portions de ces matériaux qui recouvrent les deuxièmes transistors PMOS 172 peuvent être gravées, en ayant au préalable masqué les deuxièmes transistors NMOS 170.

Le matériau 174 choisi pour remplacer le matériau de la couche 110 sous les zones actives des deuxièmes transistors NMOS 170 est avantageusement un matériau apte à mettre le matériau des zones actives des deuxièmes transistors NMOS 170 en tension afin de favoriser la mobilité des électrons de ces transistors, comme par exemple du nitrure déposé par PECVD, tel que du SiN.

L'oxyde de protection, d'épaisseur par exemple comprise entre environ 5 nm et 10 nm, formé en surface des zones de source et de drain des deuxièmes transistors 170, 172 est éliminé séquentiellement pour mettre en oeuvre les épitaxies nécessaires à la réalisation des régions de source et de drain des deuxièmes transistors 170, 172.

Les matériaux en présence permettent l'utilisation de procédés à hautes températures ce qui est favorable à la faisabilité et la qualité des deuxièmes composants électroniques.

La fin de la mise en oeuvre des étapes d'épitaxie correspond à la fin des étapes dites de « Front-End » qui mettent en jeu des températures élevées de l'ordre de 1000°C ou plus.

Les étapes d'épitaxie précédemment mises en oeuvre sont de préférence des épitaxies dopées *in situ* afin de ne pas avoir à activer thermiquement des implantations à des températures trop importantes. Les épitaxies mises en oeuvre pour la réalisation des deuxièmes composants sont avantageusement de nature similaire à celles mises en oeuvre pour la réalisation des premiers composants.

Les étapes mises en oeuvre dans la suite du procédé correspondent à des étapes dites de « Middle-End » qui mettent en jeu des températures allant jusqu'à environ 500°C, et des étapes dites de « Back-End » mettant en jeu de plus faibles budgets thermiques, correspondant à des températures inférieures à environ 400°C.

Les structures des premiers composants électroniques sont indépendantes de celles des deuxièmes composants électroniques, c'est-à-dire que les deuxièmes composants électroniques ne sont pas réalisés de manière auto-alignée par rapport aux premiers composants électroniques. Les deuxièmes composants électroniques peuvent donc être alignés ou non par rapport aux premiers composants électroniques. Les dimensions (longueurs de grille, largeurs des transistors) des premiers composants électroniques ne sont pas dépendantes de celles des deuxièmes composants électroniques.

Contrairement aux premiers composants électroniques 162, 164 dont les zones d'accès (de source et de drain pour des transistors) ne sont pas siliciurées avant le dépôt de la couche diélectrique 166, les deuxièmes composants électroniques 170, 172 sont complètement achevés notamment en formant du siliciure sur les zones d'accès de ces deuxièmes composants 170, 172.

Comme représenté sur la figure 15, une couche diélectrique 176, comportant par exemple du SiOz et dont l'épaisseur est comprise entre environ 100 nm et plusieurs centaines de nanomètres (300 nm par exemple), est ensuite déposée en recouvrant les deuxièmes composants électroniques 170, 172, puis planarisée.

Des contacts électriques, ou vias conducteurs, sont ensuite réalisés à travers la couche diélectrique 176, afin de contacter électriquement les éléments destinés à être accessibles et/ou reliés électriquement au niveau du deuxième côté du circuit 100. Ainsi, des contacts électriques 178 sont réalisés tels qu'ils soient reliés électriquement aux plans de masse 114, 116 (et traversent donc également la couche diélectrique 112). D'autres contacts électriques 180 sont réalisés tels qu'ils soient reliés à la source ou au drain des deuxièmes transistors 170, 172, et traversent donc une partie de la couche diélectrique 176 (ces contacts électriques 180 peuvent être réalisés de manière auto-alignée vis-à-vis des zones auxquelles ils sont destinés à être reliés).

Les contacts électriques peuvent être réalisés par lithographie et gravure des matériaux diélectriques, puis dépôt d'un matériau conducteur tel que du tungstène, dans ces ouvertures.

D'autres contacts électriques 182 sont réalisés à travers la couche diélectrique 176 mais également à travers d'autres couches diélectriques précédemment réalisées afin de contacter électriquement les portions conductrices des niveaux d'interconnexions électriques interposés entres les niveaux des premiers et deuxièmes composants électroniques, et réaliser ainsi des premières parties des interconnexions électriques locales qui sont destinées à relier électriquement les composants électroniques entre eux. Ces contacts électriques 182 sont ici réalisés de manière partagée, c'est-à-dire qu'ils comportent une première portion qui s'étend à travers une partie seulement de la couche diélectrique 176 et qui est reliée à la source ou au drain des deuxièmes transistors 170, 172, et une deuxième portion qui s'étend à travers toute la couche diélectrique 176 et également à travers les autres couches diélectriques précédemment réalisées afin de contacter électriquement les portions conductrices des niveaux d'interconnexions électriques interposés entre les niveaux de composants électroniques. Sur l'exemple de la figure 15, l'un de ces contacts électriques 182 comporte une première portion reliée à la source ou au drain du deuxième transistor NMOS 170 et comporte une deuxième portion, en contact avec la première portion et disposée à côté de celle-ci, qui se prolonge à travers les matériaux des couches 112, 118, 120, 126, 132 et 134 (et passe également à travers l'une des ouvertures 130 formée à travers l'écran thermique et électrostatique 128) pour contacter électriquement la portion 140. L'autre contact électrique 182 représenté comporte une première portion reliée à la source ou au drain du deuxième transistor PMOS 172 et comporte une deuxième portion, en contact avec la première portion et disposée à côté de celle-ci, qui se prolonge à travers les matériaux des couches 112 et 118 pour contacter électriquement la portion 124.

Pour réaliser un tel contact électrique 182 il est possible de réaliser tout d'abord une gravure d'un trou dans la couche diélectrique 176, au niveau d'une région dans laquelle la première portion du contact électrique 182 est destinée à être réalisée (c'est-à-dire jusqu'à atteindre la source ou le drain du transistor auquel le contact électrique doit être relié). Le trou gravé est ensuite rempli par un matériau polymère. Une gravure sélective vis-à-vis du matériau polymère est ensuite réalisée à travers le matériau diélectrique des différentes couches destinées à être traversées par la deuxième portion du contact électrique 182. Le masque utilisé pour cette gravure et le matériau polymère sont ensuite retirés ensemble. Enfin, les trous formés à travers les matériaux diélectriques sont remplis d'un matériau conducteur pour former le contact électrique 182.

Un ou plusieurs niveaux de métallisations 184 sont ensuite réalisés au niveau du deuxième côté du circuit 100. Chaque niveau de métallisations comporte une ligne métallique formée de plusieurs portions de matériau électriquement conducteur, par exemple du tungstène. Les portions conductrices du premier niveau de métallisations formé sur la couche diélectrique 176 sont reliées électriquement aux contacts électriques 178, 180 et 182 précédemment réalisés. Chaque niveau de métallisations comporte également une couche diélectrique de passivation recouvrant la ligne métallique du niveau. De plus, les lignes métalliques de deux niveaux de métallisations superposés sont reliées entre elles par des vias conducteurs formés à travers la couche diélectrique de passivation espaçant ces lignes métalliques.

Le ou les niveaux de métallisations réalisés sur le deuxième côté du circuit 100 sont ensuite recouverts par le dépôt d'un empilement de plusieurs couches alternées de diélectrique (oxyde tel que du SiO₂) et de métal afin de reconstituer un support mécanique nécessaire à la manipulation de la plaque formée par les éléments du circuit 100 précédemment réalisés. Cet empilement peut être judicieusement mis en forme et planarisé pour favoriser l'évacuation de la chaleur de fonctionnement du circuit et la manipulation de la plaque par cet empilement. Sur l'exemple de la figure 15, cet empilement est formé d'une couche diélectrique 186, comportant ici du SiO₂, d'une couche métallique 188, comportant par exemple une couche barrière de Ta et des lignes de cuivre, et enfin d'une autre couche diélectrique 190, comportant également du SiO₂. L'épaisseur de l'empilement formé par les couches 186, 188 et 190 peut être de plusieurs centaines de microns, par exemple au moins 400 µm.

En variante de l'empilement formé par les couches 186, 188 et 190, il est possible de recouvrir le dernier niveau de métallisations réalisé au niveau du deuxième côté du circuit 100 par une couche diélectrique planarisée, comportant par exemple du SiOz, et de coller cette couche diélectrique contre un substrat massif de semi-conducteur oxydé via un collage direct oxyde-oxyde, ce substrat massif formant le support mécanique nécessaire à la manipulation des éléments du circuit 100 précédemment réalisés.

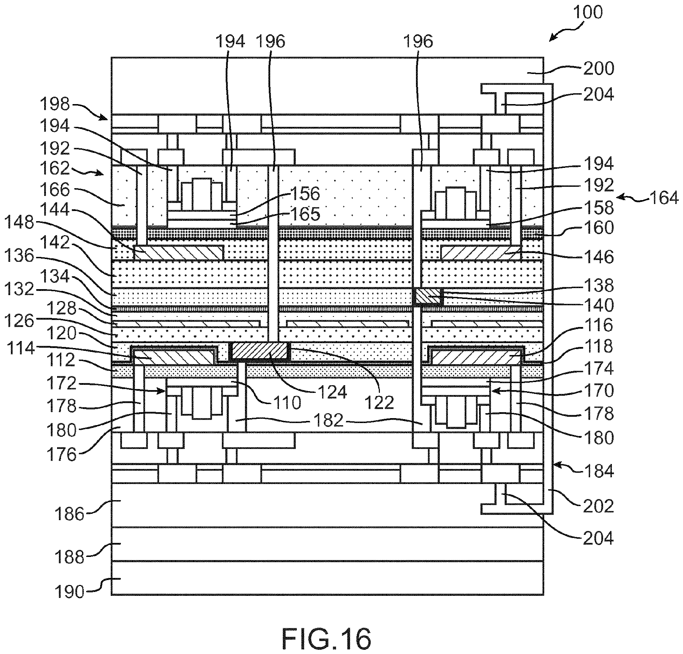

La structure réalisée est ensuite retournée et le troisième substrat 168 est retirée (figure 16).

A ce stade, comme pour les deuxièmes transistors, il est éventuellement possible de procéder au remplacement de grilles provisoires des premiers transistors, par la mise en oeuvre d'étapes similaires à celles précédemment décrites pour les deuxièmes transistors.

Des contacts électriques, ou vias conducteurs, sont ensuite réalisés à travers la couche diélectrique 166, afin de contacter électriquement les éléments destinés à être accessibles et/ou reliés électriquement au niveau du premier côté du circuit 100. Ainsi, des contacts électriques 192 sont réalisés tels qu'ils soient reliés électriquement aux plans de masse 144, 146 (et traversent donc également la couche diélectrique 160). D'autres contacts électriques 194 sont réalisés tels qu'ils soient reliés à la source ou au drain des premiers transistors 162, 164, et traversent donc une partie de la couche diélectrique 166 (ces contacts électriques 194 peuvent être réalisés de manière auto-alignée vis-à-vis des zones auxquelles ils sont destinés à être reliés).

Les contacts électriques peuvent être réalisés par lithographie et gravure des matériaux diélectriques, puis dépôt d'un matériau conducteur tel que du tungstène, dans ces ouvertures.

D'autres contacts électriques 196 sont réalisés à travers la couche diélectrique 166 mais également à travers d'autres couches diélectriques précédemment réalisées afin de contacter électriquement les portions conductrices des niveaux d'interconnexions électriques interposés entre les niveaux des premiers et deuxièmes composants électroniques, et réaliser ainsi les deuxièmes parties des interconnexions électriques locales reliant électriquement les composants électroniques entre eux. Ces contacts électriques 196 peuvent être réalisés de manière partagée, comme les contacts électriques 182 (cas du contact électrique 196 relié au premier transistor PMOS 164), ou non (cas du contact électrique 196 relié au premier transistor NMOS 162 par l'intermédiaire du premier niveau de métallisations se trouvant du premier côté du circuit 100).

Un ou plusieurs niveaux de métallisations 198 sont ensuite réalisés au niveau du premier côté du circuit 100, de manière analogue aux niveaux de métallisations 184 formés au niveau du deuxième côté du circuit 100.

Les niveaux de métallisations 198 sont enfin recouverts par une couche diélectrique de passivation 200, comportant par exemple du SiO₂.

D'autres interconnexions électriques 202 reliant des premiers composants électroniques à des deuxièmes composants électroniques, traversant une partie des couches diélectriques 200 et 186 et toutes les autres couches diélectriques se trouvant entre ces deux couches 186 et 200, peuvent également être réalisées. Ces interconnexions électriques 202 sont reliées électriquement aux premiers et deuxièmes composants par l'intermédiaire des niveaux de métallisations 184 et 198 et de vias 204 formés dans les couches 186 et 200.

Ainsi, dans le circuit 100 réalisé, des interconnexions électriques locales sont formées entre les premiers et deuxièmes composants électroniques pour les relier électriquement entre eux (soit un premier et un deuxième composants électroniques, soit deux premiers ou deux deuxièmes composants électroniques). Ces interconnexions électriques locales étant à l'échelle des composants électroniques, leurs longueurs ne dépassent pas généralement quelques centaines de nanomètres, et sont par exemple inférieures à environ 500 nm.

Bien que non visibles sur les figures précédemment décrites, des interconnexions reliées aux grilles des transistors sont également formées dans le circuit 100.

## Revendications

1. Procédé de réalisation d'un circuit électronique intégré tridimensionnel (100) comportant au moins les étapes de :
- réalisation d'une première portion de matériau électriquement conducteur (124) sur au moins une première couche diélectrique (112) recouvrant au moins une première couche de semi-conducteur (108) ; puis
- réalisation d'au moins une deuxième couche diélectrique (126, 132, 134, 136, 142, 148, 160) recouvrant au moins la première portion de matériau électriquement conducteur (124) tel que la première portion de matériau électriquement conducteur (124) soit disposée entre les première et deuxième couches diélectriques (112, 126, 132, 134, 136, 142, 148, 160), et d'au moins une deuxième couche de semi-conducteur (156) disposée sur la deuxième couche diélectrique (126, 132, 134, 136, 142, 148, 160) ; puis
- réalisationd'un premier composant électronique (162, 164) dans la deuxième couche de semi-conducteur (156) ; puis
- dépôt et planarisation d'une troisième couche diélectrique (166) recouvrant le premier composant électronique (162, 164), des siliciurations des contacts du premier composant électronique n'étant pas réalisées avant le dépôt de la troisième couche diélectrique (166) ; puis
- retournement de la structure ; puis
- solidarisation de la troisième couche diélectrique (166) à un substrat (168) ; puis
- réalisation d'un deuxième composant électronique (170, 172) dans la première couche de semi-conducteur (108), comprenant la formation de siliciure sur les zones d'accès du au moins un deuxième composant électronique (170, 172) ; puis
- dépôt et planarisation d'une quatrième couche diélectrique (176) recouvrant le deuxième composant électronique (170, 172) ; puis
- réalisation d'un premier contact (182) traversant au moins la quatrième couche diélectrique et la première couche diélectrique (112) et reliant électriquement le deuxième composant électronique (172) à la première portion de matériau électriquement conducteur (124) ; puis
- retournement de la structure ; puis
- retrait du substrat (168) ; puis
- réalisation d'un deuxième contact (196) traversant la troisième couche diélectrique (166) et au moins une partie de la deuxième couche diélectrique (126, 132, 134, 136, 142, 148, 160) et reliant électriquement le premier composant électronique (162) à la première portion de matériau électriquement conducteur (124), tels que la première portion de matériau électriquement conducteur (124) et les premier (182) et deuxième (196) contacts forment une interconnexion électrique reliant électriquement les premier (162, 164) et deuxième (170, 172) composants électriques entre eux.

2. Procédé selon la revendication 1, dans lequel le premier (162, 164) et/ou le deuxième (170, 172) composants électroniques sont des transistors de type MOS.

3. Procédé selon la revendication 2, comportant en outre, avant la réalisation de la première portion de matériau électriquement conducteur (124), la réalisation d'un premier plan de masse (114, 116) sur la première couche diélectrique (112), dans lequel la deuxième couche diélectrique (126, 132, 134, 136, 142, 148, 160) recouvre également le premier plan de masse (114, 116), et dans lequel le deuxième composant électronique (170, 172) est réalisé tel qu'une zone active du deuxième composant électronique (170, 172) soit disposée au moins en partie en regard du premier plan de masse (114, 116).

4. Procédé selon l'une des revendications 2 ou 3, comportant en outre, entre la réalisation de la première portion de matériau électriquement conducteur (124) et la réalisation du premier composant électronique (162, 164), la réalisation d'un deuxième plan de masse (144, 146) dans la deuxième couche diélectrique (126, 132, 134, 136, 142, 148, 160), et dans lequel le premier composant électronique (162, 164) est réalisé tel qu'une zone active du premier composant électronique (162, 164) soit disposée en regard du deuxième plan de masse (144, 146).

5. Procédé selon l'une des revendications précédentes, comportant en outre, avant la réalisation du premier composant électronique (162, 164), la réalisation d'un écran thermique et électrostatique (128) dans la deuxième couche diélectrique (126, 132, 134, 136, 142, 148, 160) ou entre les première (112) et deuxième (126, 132, 134, 136, 142, 148, 160) couches diélectriques et tel que l'écran thermique et électrostatique (128) et la première portion de matériau électriquement conducteur (124) soient disposés dans deux niveaux superposés l'un au-dessus de l'autre.

6. Procédé selon l'une des revendications précédentes, comportant en outre, entre la réalisation de la première portion de matériau électriquement conducteur (124) et la réalisation du premier composant électronique (162, 164), la réalisation d'une deuxième portion de matériau électriquement conducteur (140) dans la deuxième couche diélectrique (126, 132, 134, 136, 142, 148, 160) telle que les première (124) et deuxième (140) portions de matériau électriquement conducteur soient disposées dans deux niveaux superposés l'un au-dessus de l'autre.

7. Procédé selon l'une des revendications précédentes, dans lequel la première couche diélectrique (112) comporte de l'oxyde de semi-conducteur et/ou dans lequel la première portion de matériau électriquement conducteur (124) comporte du métal et/ou dans lequel la deuxième couche de semi-conducteur (156) est la couche superficielle d'un deuxième substrat SOI (150) et/ou dans lequel la deuxième couche diélectrique (126, 132, 134, 136, 142, 148, 160) comporte de l'oxyde de semi-conducteur et/ou dans lequel l'interconnexion électrique comporte du métal et/ou dans lequel la première couche de semi-conducteur (108) comporte un semi-conducteur monocristallin et/ou dans lequel la deuxième couche de semi-conducteur (156) comporte un semi-conducteur monocristallin.

8. Procédé selon l'une des revendications précédentes, dans lequel plusieurs premiers composants électroniques (162, 164) correspondant à des premiers transistors NMOS et PMOS sont réalisés dans la deuxième couche de semi-conducteur (156), et dans lequel plusieurs deuxièmes composants électroniques (170, 172) correspondant à des deuxièmes transistors NMOS et PMOS sont réalisés dans la première couche de semi-conducteur (108).

9. Procédé selon l'une des revendications 1 à 7, comportant en outre, avant la réalisation de la première portion de matériau électriquement conducteur (124), la réalisation d'une troisième couche de semi-conducteur (110) sur la première couche de semi-conducteur (108), le matériau de la troisième couche de semi-conducteur (110) étant différent du matériau de la première couche de semi-conducteur (108), et telle que la première couche diélectrique (112) recouvre la troisième couche de semi-conducteur (110), et dans lequel plusieurs deuxièmes composants électroniques (170, 172) correspondant à des deuxièmes transistors NMOS et PMOS sont réalisés tels que les zones actives des deuxièmes transistors NMOS (170) sont réalisées dans la première couche de semi-conducteur (108) et tels que les zones actives des deuxièmes transistors PMOS (172) sont réalisées dans la troisième couche de semi-conducteur (110).

10. Procédé selon l'une des revendications 1 à 7 ou 9, comportant en outre, entre la réalisation de la première portion de matériau électriquement conducteur (124) et la réalisation du premier composant électronique (162, 164), la réalisation d'une quatrième couche de semi-conducteur (158) disposée entre la deuxième couche diélectrique (126, 132, 134, 136, 142, 148, 160) et la deuxième couche de semi-conducteur (156), le matériau de la quatrième couche de semi-conducteur (158) étant différent du matériau de la deuxième couche de semi-conducteur (156), et dans lequel plusieurs premiers composants électroniques (162, 164) correspondant à des premiers transistors NMOS et PMOS sont réalisés tels que les zones actives des premiers transistors NMOS (162) sont réalisées dans la deuxième couche de semi-conducteur (156) et tels que les zones actives des premiers transistors PMOS (164) sont réalisées dans la quatrième couche de semi-conducteur (158).

11. Procédé selon l'une des revendications précédentes, dans lequel la première couche de semi-conducteur (108) est la couche superficielle d'un premier substrat SOI (102), et dans lequel la couche massive (104) et la couche diélectrique enterrée (106) du premier substrat SOI (102) sont désolidarisées de la première couche de semi-conducteur (108) après la réalisation du premier composant électronique (162, 164) et avant la réalisation du deuxième composant électronique (170, 172).

12. Procédé selon l'une des revendications précédentes, dans lequel le premier contact (182) est réalisé en gravant un premier trou à travers la première couche diélectrique (112) et en remplissant le premier trou d'un matériau électriquement conducteur, puis le deuxième contact (196) est réalisé en gravant un deuxième trou à travers au moins une partie de la deuxième couche diélectrique (126, 132, 134, 136, 142, 148, 160) et en remplissant le deuxième trou du matériau électriquement conducteur.

13. Procédé selon la revendication 12, comportant en outre, après la réalisation du premier contact (182), la réalisation d'un ou plusieurs premiers niveaux de métallisations (184) sur le deuxième composant électronique (170, 172), et comportant en outre, après la réalisation du deuxième contact (196), la réalisation d'un ou plusieurs deuxièmes niveaux de métallisations (198) sur le premier composant électronique (162, 164).

## Patentansprüche

1. Verfahren zur Herstellung eines dreidimensionalen integrierten elektronischen Schaltkreises (100), das mindestens die folgenden Schritte umfasst:
- Herstellen eines ersten Abschnitts aus elektrisch leitendem Material (124) auf mindestens einer ersten dielektrischen Schicht (112), die mindestens eine erste Halbleiterschicht (108) bedeckt; dann
- Herstellen von mindestens einer zweiten dielektrischen Schicht (126, 132, 134, 136, 142, 148, 160), die mindestens den ersten Abschnitt aus elektrisch leitendem Material (124) bedeckt, derart, dass der erste Abschnitt aus elektrisch leitendem Material (124) zwischen der ersten und der zweiten dielektrischen Schicht (112, 126, 132, 134, 136, 142, 148, 160) angeordnet ist, und von mindestens einer zweiten Halbleiterschicht (156), die auf der zweiten dielektrischen Schicht (126, 132, 134, 136, 142, 148, 160) angeordnet ist; dann
- Herstellen eines ersten elektronischen Bauteils (162, 164) in der zweiten Halbleiterschicht (156); dann
- Abscheiden und Planarisieren einer dritten dielektrischen Schicht (166), die das erste elektronische Bauteil (162, 164) bedeckt, wobei Silizierungen der Kontakte des ersten elektronischen Bauteils nicht vor dem Abscheiden der dritten dielektrischen Schicht (166) hergestellt werden; dann
- Umdrehen der Struktur; dann
- Befestigen der dritten dielektrischen Schicht (166) an einem Substrat (168); dann
- Herstellen eines zweiten elektronischen Bauteils (170, 172) in der ersten Halbleiterschicht (108), das das Bilden von Silicid an den Zugangszonen des mindestens einen zweiten elektronischen Bauteils (170, 172) umfasst; dann
- Abscheiden und Planarisieren einer vierten dielektrischen Schicht (176), die das zweite elektronische Bauteil (170, 172) bedeckt; dann
- Herstellen eines ersten Kontakts (182), der mindestens durch die vierte dielektrische Schicht und die erste dielektrische Schicht (112) hindurchgeht und das zweite elektronische Bauteil (172) elektrisch mit dem ersten Abschnitt aus elektrisch leitendem Material (124) verbindet; dann
- Umdrehen der Struktur; dann
- Entfernen des Substrats (168); dann
- Herstellen eines zweiten Kontakts (196), der durch die dritte dielektrische Schicht (166) und mindestens einen Teil der zweiten dielektrischen Schicht (126, 132, 134, 136, 142, 148, 160) hindurchgeht und das erste elektronische Bauteil (162) elektrisch mit dem ersten Abschnitt aus elektrisch leitendem Material (124) verbindet, derart, dass der erste Abschnitt aus elektrisch leitendem Material (124) und der erste (182) und der zweite (196) Kontakt eine elektrische Verbindung bilden, die das erste (162, 164) und das zweite (170, 172) elektrische Bauteil elektrisch miteinander verbinden.

2. Verfahren nach Anspruch 1, wobei es sich beim ersten (162, 164) und/oder dem zweiten (170, 172) elektronischen Bauteil um Transistoren vom MOS-Typ handelt.

3. Verfahren nach Anspruch 2, das vor dem Herstellen des ersten Abschnitts aus elektrisch leitendem Material (124) weiter das Herstellen einer ersten Masseebene (114, 116) auf der ersten dielektrischen Schicht (112) umfasst, wobei die zweite dielektrische Schicht (126, 132, 134, 136, 142, 148, 160) ebenfalls die erste Masseebene (114, 116) bedeckt, und wobei das zweite elektronische Bauteil (170, 172) derart hergestellt wird, dass eine aktive Zone des zweiten elektronischen Bauteils (170, 172) mindestens zum Teil der ersten Masseebene (114, 116) zugewandt angeordnet ist.

4. Verfahren nach einem der Ansprüche 2 oder 3, das zwischen dem Herstellen des ersten Abschnitts aus elektrisch leitendem Material (124) und dem Herstellen des ersten elektronischen Bauteils (162, 164) weiter das Herstellen einer zweiten Masseebene (144, 146) in der zweiten dielektrischen Schicht (126, 132, 134, 136, 142, 148, 160) umfasst, und wobei das erste elektronische Bauteil (162, 164) derart hergestellt wird, dass eine aktive Zone des ersten elektronischen Bauteils (162, 164) der zweiten Masseebene (144, 146) zugewandt angeordnet ist.

5. Verfahren nach einem der vorstehenden Ansprüche, das vor dem Herstellen des ersten elektronischen Bauteils (162, 164) weiter das Herstellen einer thermischen und elektrostatischen Abschirmung (128) in der zweiten dielektrischen Schicht (126, 132, 134, 136, 142, 148, 160) oder zwischen der ersten (112) und der zweiten (126, 132, 134, 136, 142, 148, 160) dielektrischen Schicht und derart umfasst, dass die thermische und elektrostatische Abschirmung (128) und der erste Abschnitt aus elektrisch leitendem Material (124) in zwei übereinanderliegenden Ebenen übereinander angeordnet sind.

6. Verfahren nach einem der vorstehenden Ansprüche, das zwischen dem Herstellen des ersten Abschnitts aus elektrisch leitenden Material (124) und dem Herstellen des ersten elektronischen Bauteils (162, 164) weiter das Herstellen eines zweiten Abschnitts aus elektrisch leitendem Material (140) in der zweiten dielektrischen Schicht (126, 132, 134, 136, 142, 148, 160) derart umfasst, dass der erste (124) und der zweite (140) Abschnitt aus elektrisch leitendem Material in zwei übereinanderliegenden Ebenen übereinander angeordnet sind.

7. Verfahren nach einem der vorstehenden Ansprüche, wobei die erste dielektrische Schicht (112) Halbleiteroxid umfasst, und/oder wobei der erste Abschnitt aus elektrisch leitendem Material (124) Metall umfasst, und/oder wobei es sich bei der zweiten Halbleiterschicht (156) um die Oberflächenschicht eines zweiten SOI-Substrats (150) handelt, und/oder wobei die zweite dielektrische Schicht (126, 132, 134, 136, 142, 148, 160) Halbleiteroxid umfasst, und/oder wobei die elektrische Verbindung Metall umfasst, und/oder wobei die erste Halbleiterschicht (108) einen monokristallinen Halbleiter umfasst, und/oder wobei die zweite Halbleiterschicht (156) einen monokristallinen Halbleiter umfasst.

8. Verfahren nach einem der vorstehenden Ansprüche, wobei mehrere erste elektronische Bauteile (162, 164), die ersten NMOS- und PMOS-Transistoren entsprechen, in der zweiten Halbleiterschicht (156) hergestellt werden, und wobei mehrere zweite elektronische Bauteile (170, 172), die zweiten NMOS- und PMOS-Transistoren entsprechen, in der ersten Halbleiterschicht (108) hergestellt werden.

9. Verfahren nach einem der Ansprüche 1 bis 7, das vor dem Herstellen des ersten Abschnitts aus elektrisch leitendem Material (124) weiter das Herstellen einer dritten Halbleiterschicht (110) auf der ersten Halbleiterschicht (108), wobei sich das Material der dritten Halbleiterschicht (110) vom Material der ersten Halbleiterschicht (108) unterscheidet, und derart umfasst, dass die erste dielektrische Schicht (112) die dritte Halbleiterschicht (110) bedeckt, und wobei mehrere zweite elektronische Bauteile (170, 172), die zweiten NMOS- und PMOS-Transistoren entsprechen, derart hergestellt werden, dass die aktiven Zonen der zweiten NMOS-Transistoren (170) in der ersten Halbleiterschicht (108) hergestellt werden, und derart, dass die aktiven Zonen der zweiten PMOS-Transistoren (172) in der dritten Halbleiterschicht (110) hergestellt werden.

10. Verfahren nach einem der Ansprüche 1 bis 7 oder 9, das zwischen dem Herstellen des ersten Abschnitts aus elektrisch leitendem Material (124) und dem Herstellen des ersten elektronischen Bauteils (162, 164) weiter das Herstellen einer vierten Halbleiterschicht (158) umfasst, die zwischen der zweiten dielektrischen Schicht (126, 132, 134, 136, 142, 148, 160) und der zweiten Halbleiterschicht (156) angeordnet ist, wobei sich das Material der vierten Halbleiterschicht (158) vom Material der zweiten Halbleiterschicht (156) unterscheidet, und wobei mehrere erste elektronische Bauteile (162, 164), die ersten NMOS- und PMOS-Transistoren entsprechen, derart hergestellt werden, dass die aktiven Zonen der ersten NMOS-Transistoren (162) in der zweiten Halbleiterschicht (156) hergestellt werden, und derart, dass die aktiven Zonen der ersten PMOS-Transistoren (164) in der vierten Halbleiterschicht (158) hergestellt werden.

11. Verfahren nach einem der vorstehenden Ansprüche, wobei es sich bei der ersten Halbleiterschicht (108) um die Oberflächenschicht eines ersten SOI-Substrats (102) handelt, und wobei die Massenschicht (104) und die eingebettete dielektrische Schicht (106) des ersten SOI-Substrats (102) nach dem Herstellen des ersten elektronischen Bauteils (162, 164) und vor dem Herstellen des zweiten elektronischen Bauteils (170, 172) von der ersten Halbleiterschicht (108) gelöst werden.

12. Verfahren nach einem der vorstehenden Ansprüche, wobei der erste Kontakt (182) durch Ätzen eines ersten Lochs durch die erste dielektrische Schicht (112) und durch Füllen des ersten Lochs mit einem elektrisch leitenden Material hergestellt wird, dann der zweite Kontakt (196) durch Ätzen eines zweiten Lochs durch mindestens einen Teil der zweiten dielektrischen Schicht (126, 132, 134, 136, 142, 148, 160) und durch Füllen des zweiten Lochs mit dem elektrisch leitenden Material hergestellt wird.

13. Verfahren nach Anspruch 12, das nach dem Herstellen des ersten Kontakts (182) weiter das Herstellen von einer oder mehreren ersten Metallisierungsebenen (184) auf dem zweiten elektronischen Bauteil (170, 172) umfasst, und nach dem Herstellen des zweiten Kontakts (196) weiter das Herstellen von einer oder mehreren zweiten Metallisierungsebenen (198) auf dem ersten elektronischen Bauteil (162, 164) umfasst.

## Claims

1. Method for making a three-dimensional integrated electronic circuit (100) comprising at least steps for:
- making a first portion of electrically conductive material (124) on at least one first dielectric layer (112) covering at least one first semiconductor layer (108); then
- making at least one second dielectric layer (126, 132, 134, 136, 142, 148, 160) covering at least the first portion of electrically conductive material (124) such that the first portion of electrically conductive material (124) is arranged between the first and second dielectric layers (112, 126, 132, 134, 136, 142, 148, 160), and at least one second semiconductor layer (156) arranged on the second dielectric layer (126, 132, 134, 136, 142, 148, 160); then
- making a first electronic component (162, 164) in the second semiconductor layer (156); then
- deposition and planarization of a third dielectric layer (166) covering the first electronic component (162, 164), silicides of contacts of the first electronic component being not made before the deposition of the third dielectric layer (166); then
- turning over of the structure; then
- firmly attaching the third dielectric layer (166) to a substrate (168); then
- making a second electronic component (170, 172) in the first semiconductor layer (108), comprising the making of silicide on the access areas of the at least one second electronic component (170, 172); then
- deposition and planarization of a fourth dielectric layer (176) covering the second electronic component (170, 172); then
- making a first contact (182) through at least the fourth dielectric layer and the first dielectric layer (112) and electrically connecting the second electronic component (172) to the first portion of electrically conductive material (124); then
- turning over of the structure; then
- removal of the substrate (168); then
- making a second contact (196) through the third dielectric layer (166) and at least a part of the second dielectric layer (126, 132, 134, 136, 142, 148, 160) and electrically connecting the first electronic component (162) to the first portion of electrically conductive material (124), such that the first portion of electrically conductive material (124) and the first (182) and second (196) contacts form an electrical interconnection electrically linking the first (162, 164) and second (170, 172) electronic components together.

2. Method according to claim 1, wherein the first (162, 164) and/or the second (170, 172) electronic components are MOS type transistors.

3. Method according to claim 2, further comprising, before making the first portion of electrically conductive material (124), making a first ground plane (114,116) on the first dielectric layer (112), wherein the second dielectric layer (126, 132, 134, 136, 142, 148, 160) also covers the first ground plane (114, 116), and wherein the second electronic component (170, 172) is made such that an active zone of the second electronic component (170, 172) is arranged at least in part facing the first ground plane (114, 116).

4. Method according to one of claims 2 or 3, further comprising, between making the first portion of electrically conductive material (124) and making the first electronic component (162, 164), making a second ground plane (144, 146) in the second dielectric layer (126, 132, 134, 136, 142, 148, 160), and wherein the first electronic component (162, 164) is made such that an active zone of the first electronic component (162, 164) is arranged facing the second ground plane (144, 146).

5. Method according to one of previous claims, further comprising, before making the first electronic component (162, 164), making a thermal and electrostatic screen (128) in the second dielectric layer (126, 132, 134, 136, 142, 148, 160) or between the first (112) and second (126, 132, 134, 136, 142, 148, 160) dielectric layers and such that the thermal and electrostatic screen (128) and the first portion of electrically conductive material (124) are arranged in two levels superposed one above the other.

6. Method according to one of previous claims, further comprising between making the first portion of electrically conductive material (124) and making the first electronic component (162, 164), making a second portion of electrically conductive material (140) in the second dielectric layer (126, 132, 134, 136, 142, 148, 160) such that the first (124) and second (140) portions of electrically conductive materials are arranged in two levels superimposed one above the other.

7. Method according to one of previous claims, wherein the first dielectric layer (112) comprises semiconductor oxide and/or wherein the first portion of electrically conductive material (124) comprises metal and/or wherein the second semiconductor layer (156) is the surface layer of a second SOI substrate (150) and/or wherein the second dielectric layer (126, 132, 134, 136, 142, 148, 160) comprises semiconductor oxide and/or wherein the electrical interconnection comprises metal and/or wherein the first semiconductor layer (108) comprises a single-crystal semiconductor and/or wherein the second semiconductor layer (156) comprises a single-crystal semiconductor.

8. Method according to one of previous claims, wherein several first electronic components (162, 164) corresponding to first NMOS and PMOS transistors are made in the second semiconductor layer (156), and wherein several second electronic components (170, 172) corresponding to second NMOS and PMOS transistors are made in the first semiconductor layer (108).

9. Method according to one of claims 1 to 7, further comprising, before making the first portion of electrically conductive material (124), making a third semiconductor layer (110) on the first semiconductor layer (108), wherein the material of the third semiconductor layer (110) is different from the material of the first semiconductor layer (108), and such that the first dielectric layer (112) covers the third semiconductor layer (110), and wherein several second electronic components (170, 172) corresponding to second NMOS and PMOS transistors are made such that the active zones of the second NMOS transistors (170) are made in the first semiconductor layer (108) and such that the active zones of the second PMOS transistors (172) are made in the third semiconductor layer (110).

10. Method according to one of claims 1 to 7 or 9, further comprising, between making the first portion of electrically conductive material (124) and making the first electronic component (162, 164), making a fourth semiconductor layer (158) arranged between the second dielectric layer (126, 132, 134, 136, 142, 148, 160) and the second semiconductor layer (156), wherein the material of the fourth semiconductor layer (158) is different from the material of the second semiconductor layer (156), and wherein several first electronic components (162, 164) corresponding to first NMOS and PMOS transistors are made such that the active zones of the first NMOS transistors (162) are made in the second semiconductor layer (156) and such that the active zones of the first PMOS transistors (164) are made in the fourth semiconductor layer (158).

11. Method according to one of previous claims, wherein the first semiconductor layer (108) is the surface layer of a first SOI substrate (102) and wherein the bulk layer (104) and the buried dielectric layer (106) of the first SOI substrate (102) are separated from the first semiconductor layer (108) after making the first electronic component (162, 164) and before making the second electronic component (170, 172).

12. Method according to one of previous claims, wherein the first contact (182) is made by etching a first hole through the first dielectric layer (112) and by filling the first hole with an electrically conductive material, then the second contact (196) is made by etching a second hole through at least one part of the second dielectric layer (126, 132, 134, 136, 142, 148, 160) and by filling the second hole with electrically conductive material.

13. Method according to claim 12, further comprising, after making the first contact (182), making one or more first metallisation levels (184) on the second electronic component (170, 172), and further comprising, after making the second contact (196), making one or more second metallisation levels (198) on the first electronic component (162, 164).
